# EUROPEAN PATENT APPLICATION

(11) **EP 4 528 802 A1**
(43) Date of publication of application: **26.03.2025**
(21) Application number: 23807617.8
(22) Date of filing: 15.05.2023
(51) Int. Cl.: H01L 23/473, H05K 7/20

(54) **COOLING STRUCTURE AND STRUCTURE**

(30) Priority: 16.05.2022 JP 2022080052
(71) Applicant: Resonac Corporation, Tokyo 105-7325 (JP)
(72) Inventor: FUKUKAWA, Yuji, Tokyo 105-8518 (JP); YAMASHITA, Takahiro, Tokyo 105-8518 (JP); ITO, Seiichi, Tokyo 105-8518 (JP); SHODA, Hiroaki, Tokyo 105-8518 (JP)
(74) Representative: Berggren Oy
(86) International application number: PCT/JP2023/018174
(87) International publication number: WO 2023/224015

(57) **Abstract**

A cooling structure includes an outer packaging material having an inlet and an outlet for a refrigerant, and an inner core material disposed inside the outer packaging material, in which the inner core material has a concave and convex shape that divides the flow path of the refrigerant into multiple sections, and at least one of an inclination from a concave portion to a convex portion or an inclination from a convex portion to a concave portion in the concave and convex shape is 10° or more and less than 90° with respect to a surface direction of the cooling structure.

## Description

### Technical field

The present disclosure relates to a cooling structure, and a structure.

### Background Art

In the field of electronic devices such as smartphones and personal computers, and battery modules mounted on electric vehicles, hybrid vehicles and the like, techniques for incorporating water-cooling devices, heat pipes and the like as heat generation countermeasures are known. Also, in power semiconductor modules made of silicon carbide or the like, measures using cooling plates, heat sinks or the like as heat generation countermeasures have been proposed.

For example, vehicles equipped with motors such as hybrid cars and electric cars, are equipped with a driving means for driving the motor. The driving means is composed of a power module having a plural power semiconductor such as an IGBT (Insulated Gate Bipolar Transistor), an electronic component such as a capacitor, and a bus bar that electrically connect these electronic components. When driving a motor, a large current may flow through the bus bar that connects the power semiconductors, capacitors and the like. In this case, the driving means generates heat due to switching loss, resistance loss and the like, and therefore it is desirable to efficiently cool the driving means. It is also desirable to efficiently cool the heat generated by the battery module installed in the vehicle.

A cooling structure may be a structure made of a metal with high thermal conductivity, such as an aluminum cooling fin core structure. However, since it is made of metal, it is heavy, and since it needs to be attached to an object to be cooled by welding or the like, it needs to be a certain thickness, which makes it difficult to make it thin.

Therefore, from the viewpoint of reducing weight and the like, a cooling structure has been proposed in which an outer packaging material and an inner core material are made of a laminate material in which a metal heat transfer layer is laminated with resin layer, and a refrigerant is circulated through a flow path separated by the inner core material (see, for example, Patent Document 1). It is described that a heat exchanger of Patent Document 1 can be sufficiently thinned because it is produced by heat-fusing laminate materials having a heat fusion layer. Furthermore, in the heat exchanger described in Patent Document 1, the shape and size of the laminated materials that serve as the exterior material and the inner core material can be easily changed, which is said to increase design freedom and improve versatility.

### Related Art Documents

### Patent Documents

Patent Document 1: Japanese Patent Application Laid-Open (JP-A) No. 2020-3132

### SUMMARY OF INVENTION

Although the heat exchanger described in Patent Document 1 has the above advantages, a technique for further improving the heat exchange efficiency is desired. In view of such circumstances, the present disclosure relates to providing a cooling structure and a structure that have excellent heat exchange efficiency.

### Solution to Problem

Means for solving the above problems include the following embodiments.
<1> A cooling structure comprising an outer packaging material having an inlet and an outlet for a refrigerant, and an inner core material disposed inside the outer packaging material,
   in which the inner core material has a concave and convex shape that divides a flow path of the refrigerant into multiple sections, and
   in which at least one of an inclination from a concave portion to a convex portion or an inclination from a convex portion to a concave portion in the concave and convex shape is 10° or more and less than 90° with respect to a surface direction of the cooling structure.
<2> The cooling structure according to <1>, in which at least one of a bottom of the concave portion or a top of the convex portion has a flat surface.
<3> The cooling structure according to <2>, in which the flat surface is fused to the outer packaging material.
<4> The cooling structure according to any one of <1> to <3>, in which the outer packaging material includes a metal layer and a resin layer provided on at least one surface of the metal layer.
<5> The cooling structure according to any one of <1> to <4>, in which the inner core material includes a metal layer and a resin layer provided on both surfaces of the metal layer.
<6> The cooling structure according to any one of <1> to <5>, in which the inner core material is made of an elastically deformable material.
<7> The cooling structure according to any one of <1> to <6>, in which at least one of a spacing between concave portions or a spacing between convex portions is from 2 mm to 10 mm.
<8> A structure including the cooling structure according to any one of <1> to <7> and an object to be cooled provided on the cooling structure.

### Advantageous Effects of Invention

According to the present disclosure, it is possible to provide a cooling structure and a structure that have excellent heat exchange efficiency.

### BRIEF DESCRIPTION OF DRAWINGS

FIG. 1 is a schematic partial cross-sectional view in the width direction of a cooling structure according to one embodiment in the present disclosure.
FIG. 2 is a schematic partial cross-sectional view in the width direction of a cooling structure in a case in which inclinations θ1 and θ2 are 90°.
FIG. 3 is a schematic perspective view showing an appearance of a cooling structure according to one embodiment in the present disclosure.
FIG. 4 is an exploded view of the cooling structure of FIG. 3 separated into its individual components.
FIG. 5 is a schematic perspective view illustrating a modified example of the cooling structure, showing an interior in a case in which an upper outer packaging material is removed.

### DESCRIPTION OF EMBODIMENTS

Hereinafter, embodiments in the present disclosure will be described in detail. It is to be noted, however, that the present disclosure is not limited to the following embodiments. In the embodiments described below, components thereof (including element steps and the like) are not essential, unless otherwise specified. The same applies to numerical values and ranges thereof, and the present disclosure is not limited thereto.

In a case in which the embodiments in the present disclosure are described with reference to the drawings, a configuration of embodiments is not limited to the configuration shown in the drawings. Furthermore, the sizes of the members in each figure are conceptual, and the relative size relationships between the members are not limited thereto. Further, in each drawing, members having substantially the same function are given the same reference numerals in all drawings, and duplicated explanations will be omitted.

In the present disclosure, the term "layer" comprehends herein not only a case in which the layer is formed over the whole observed region where the layer is present, but also a case in which the layer is formed only on part of the region.

In the present disclosure, the term "laminate" refers to stacking layers, and two or more layers may be joined, or two or more layers may be detachable.

### <Cooling structure>

A cooling structure in the present disclosure is a cooling structure including an outer packaging material having an inlet and an outlet for a refrigerant, and an inner core material disposed inside the outer packaging material, in which the inner core material has a concave and convex shape that divides the flow path of the refrigerant into multiple sections, and at least one of an inclination from a concave portion to a convex portion or an inclination from a convex portion to a concave portion in the concave and convex shape is 10° or more and less than 90° with respect to a surface direction of the cooling structure.

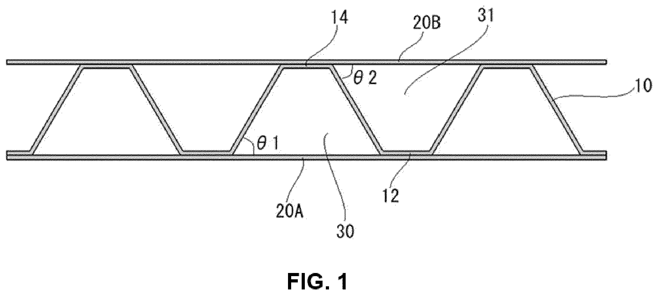

FIG. 1 shows a schematic partial cross-sectional view in the width direction (Orthogonal to the direction of refrigerant flow) of a cooling structure according to one embodiment in the present disclosure. The inner core material 10 has a concave and convex shape that divides a flow path of the refrigerant into multiple sections. And at least one of an inclinations θ1 from a concave portion 12 to a convex portion 14 or an inclination θ2 from a convex portion 14 to a concave portion 12 in the concave and convex shape is 10° or more and less than 90° with respect to a surface direction of the cooling structure. The concave portion 12 and the convex portion 14 of the inner core material 10 contact outer packaging materials 20A and 20B, respectively, and divide the flow path of the refrigerant into multiple sections, forming flow paths 30, 31 and the like. The outer packaging materials 20A and 20B are also collectively referred to as the outer packaging materials 20.

In a case in which an object to be cooled that is placed on the outer packaging material 20A side is cooled, if we focus on flow path 30, it is cooled by the refrigerant in flow path 30 through the outer packaging material 20A. Focusing on flow path 31, it is cooled by the refrigerant in flow path 31 through the outer packaging material 20A and the inner core material 10. In other words, in the flow path 31, the refrigerant moves away from the object to be cooled by a distance equal to a total thickness of the outer packaging material 20A and the inner core material 10.

Similarly, in a case in which c an object to be cooled that is placed on the outer packaging material 20B side is cooled,, if we focus on flow path 31, it is cooled by the refrigerant in flow path 31 through the outer packaging material 20B. Focusing on the flow path 30, it is cooled by the refrigerant in flow path 30 through the outer packaging material 20B and the inner core material 10. In other words, in the flow path 30, the refrigerant moves away from the object to be cooled by a distance equal to a total thickness of the outer packaging material 20B and the inner core material 10.

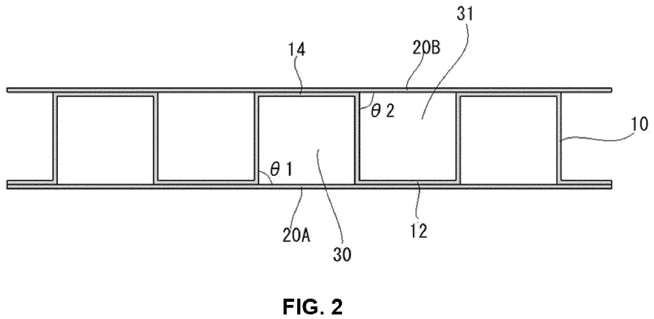

FIG. 2 is a schematic partial cross-sectional view in the width direction of a cooling structure in a case in which inclinations θ1 and θ2 are 90°. FIGs 1 and 2 are shown so that the intervals between the convex portions are the same. The cooling structure in FIG. 1, in which at least one of the inclinations θ1 or θ2 is 10° or more and less than 90°, has a smaller contact area between the outer packaging material 20A and the concave portion 12, and a smaller contact area between the outer packaging material 20B and the convex portion 14, compared to the cooling structure in FIG. 2, in which the inclinations θ1 and θ2 are 90°. Therefore, the cooling structure in FIG. 1 has a superior heat exchange efficiency to the cooling structure in FIG. 2.

In addition, in a case in which the cooling structure is pressed against the object to be cooled, which is a heat generating body, in the cooling structure of FIG. 1, the inner core material 10 is partially inclined in the thickness direction, so that the pressing force in the thickness direction can be released in the surface direction, and it is also possible to suppress damage to the inner core material 10 due to pressing.

Here, the inclination θ1 refers to an acute angle of an inclination from the concave portion 12 to the convex portion 14 with respect to the surface direction of the cooling structure. The inclination θ2 refers to an acute angle of the inclination from the convex portion 14 to the concave portion 12 with respect to the surface direction of the cooling structure. The inclination from the concave portion 12 to the convex portion 14 and the inclination from the convex portion 14 to the concave portion 12 do not have to be uniform.

In a case in which an inclination from the concave portion 12 to the convex portion 14 is not uniform, the inclination of the inner core material 10 from the concave portion 12 to the convex portion 14 is approximated as a straight line A, and an acute angle between this straight line A and the surface direction of the cooling structure is the inclination θ1. In a case in which an inclination from the convex portion 14 to the concave portion 12 is not uniform, the inclination of the inner core material 10 from the concave portion 12 to the convex portion 14 is approximated as a straight line B, and an acute angle between this straight line B and the surface direction of the cooling structure is the inclination θ2.

In FIG. 1, a bottom of the concave portion 12 and a top of the convex portion 14 are shown as flat surfaces, but they may be curved surfaces instead of flat surfaces. It is preferable that at least one of the bottom of the concave portion 12 or the top of the convex portion 14 has a flat surface. In a case in which at least one of the bottom of the concave portion 12 or the top of the convex portion 14 has a flat surface, it becomes easier to fuse the inner core material 10 to the outer packaging material 20. In a case in which at least one of the concave portion 12 or the convex portion 14 of the inner core material 10 is fused to the outer packaging material 20, a positional deviation of the inner core material 10 is suppressed.

In the cooling structure of FIG. 2 having the inclinations θ1 and θ2 of 90°, if intervals between the convex portions and the intervals between the concave portions are reduced for reducing the contact area between the outer packaging material 20 and the inner core material 10, a total number of convex portions and processing cost will increase. Note that even if the intervals between the convex portions and the intervals between the concave portions is reduced, a total contact area between the outer packaging material 20 and the inner core material 10 will not decrease.

From the same viewpoint, in the cooling structure of FIG. 2 having the inclinations θ1 and θ2 of 90°, if the bottom of the concave portion 12 and the top of the convex portion 14 are curved, a contact between the inner core material 10 and the outer packaging material 20 will be point contact or line contact, making it difficult to fuse the inner core material 10 to the outer packaging material 20. In a case in which the outer packaging material 20 and the inner core material 10 are firmly fused, it will be easier to withstand the internal pressure caused by the flow of the refrigerant.

The inclinations θ1 and θ2 may be the same or different. From the viewpoints of simplifying manufacturing and strength, it is preferable that the inclination θ1 and the inclination θ2 are the same.

Each of the inclination θ1 and the inclination θ2 is independently 10° or more, preferably 20° or more, more preferably 30° or more, and even more preferably 45° or more. Each of the inclination θ1 and the inclination θ2 is independently less than 90°, preferably 80° or less, more preferably 70° or less, and even more preferably 60° or less.

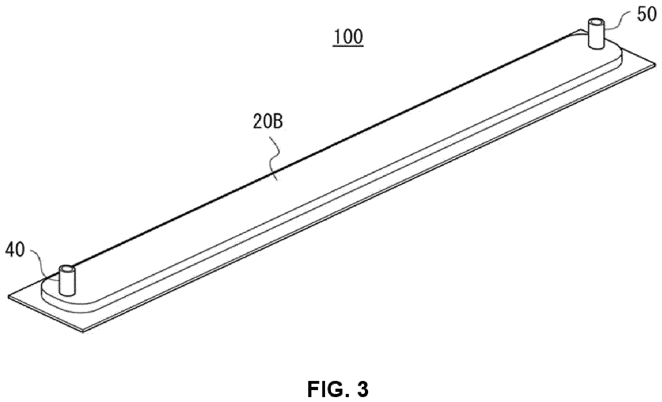

FIG. 3 is a schematic perspective view showing an appearance of a cooling structure 100 according to one embodiment in the present disclosure. The cooling structure 100 shown in FIG. 3 has an inlet 40 and an outlet 50 for a refrigerant, and is entirely covered with an outer packaging material 20.

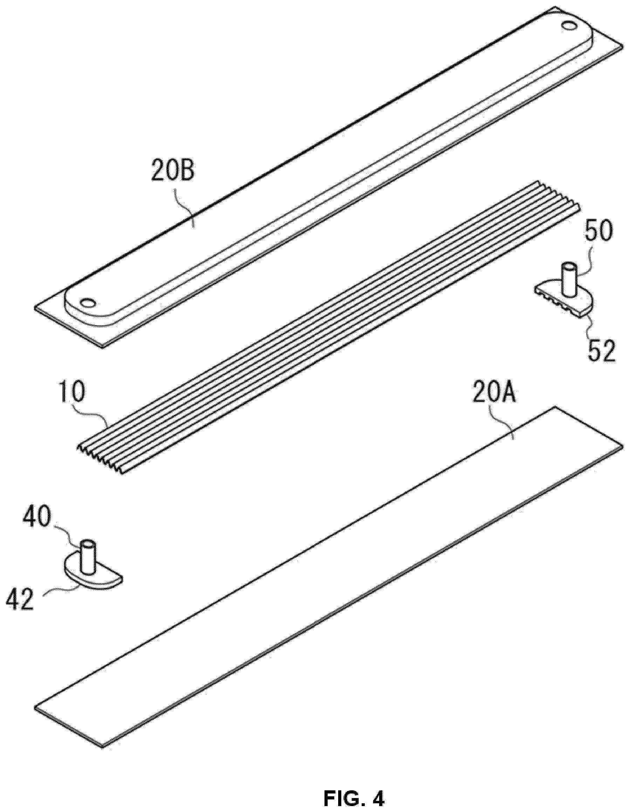

FIG. 4 is an exploded view of the cooling structure 100 of FIG. 3, separated into its individual components.

The outer packaging material 20 is composed of an upper outer packaging material 20A and a lower outer packaging material 20B. In the present disclosure, the upper and lower are written according to a top and bottom in the drawings, but the top and bottom may be reversed.

A material of the outer packaging material 20 is not particularly limited, but is preferably a metal from the viewpoint of thermal conductivity. Examples of the outer packaging material 20 include aluminum foil, stainless steel foil, nickel foil, plated copper foil, and clad metal of nickel foil and copper foil. From the viewpoint of thermal conductivity, cost or the like, aluminum foil is preferable.

In one embodiment, the outer packaging material 20 may have a metal layer and a resin layer provided on at least one surface of the metal layer. By providing a resin layer on an inside surface of the outer packaging material 20, an occurrence of corrosion due to the refrigerant is easily suppressed. Whereas, by providing a resin layer on the outside surface of the outer packaging material 20, insulation may be achieved. The metal layer and the resin layer may be laminated to form a laminate material. Another layer may or may not be provided between the metal layer and the inner resin layer. The lower outer packaging material 20A and the upper outer packaging material 20B may be made of the same material or different materials.

The metal layer in the laminate material is preferably made of the metals mentioned above.

The resin layer in the laminate material is preferably composed of a resin having thermal fusion property, and examples of the resin include a polyolefin resin such as polyethylene, polypropylene or modified resins thereof, a fluorine-based resin, a polyester resin such as PET resin, and vinyl chloride resin.

A thickness of the metal layer is preferably 4 µm or more, and more preferably 8 µm or more. The thickness of the metal layer is preferably 300 µm or less, and more preferably 150 µm or less.

A thickness of the resin layer is preferably 4 µm or more, and more preferably 8 µm or more. The thickness of the resin layer is preferably 300 µm or less, and more preferably 150 µm or less.

A coating layer may be provided on the outermost layer of the laminate material. By providing the coating layer on the outer packaging material 20, a corrosion of the metal layer is prevented, and damage due to external and internal pressure tends to be prevented. In addition, in a case in which an insulating resin is used for the coating layer, it tends to be possible to impart effects such as preventing short circuits and electric leakage to the object to be cooled. Whereas, in a case in which a conductive resin is used for the coating layer, it tends to be possible to impart an antistatic effect to the object to be cooled.

As the resin for the coating layer, the same resin as that for the resin layer described above may be used. The coating layer may be made of the same material as the resin layer, or a different material. From the viewpoint of fusing between the outer packaging material 20 and the inner core material 10, it is preferable to use a coating layer having a higher melting point than the resin layer, and it is particularly preferable to use a resin having a melting point 10°C or more higher.

A thickness of the coating layer is not particularly limited, and it is preferable to set it to the same thickness as the resin layer or thinner than the resin layer.

A thickness of the outer packaging material 20 is not particularly limited. From the viewpoint of strength and thermal conductivity, it is preferable that the thickness of the outer packaging material 20 is 8 µm or more, more preferably 10 µm or more, and even more preferably 12 µm or more. From the viewpoint of thinning and deformability, it is preferable that the thickness of the outer packaging material 20 is 300 µm or less, more preferably 250 µm or less, and even more preferably 200 µm or less. From these viewpoints, the thickness of the outer packaging material 20 is preferably from 8 µm to 300 µm, more preferably from 10 µm to 250 µm, and even more preferably from 12 µm to 200 µm.

The laminate material may be produced by attaching a resin film to a metal foil or metal plate. The resin film may be a stretched film or a non-stretched film. An adhesive may be used for attachment.

In FIG. 4, the upper outer packaging material 20B is provided with holes for passing through a joint pipe as the inlet 40 and a joint pipe as the outlet 50. From the viewpoint of fixing the joint pipes and assembling, it is preferable that the joint pipe of the inlet 40 is provided as a part of a header part 42, and the joint pipe of the outlet 50 is provided as a part of a footer part 52. The joint pipe of the inlet 40 may be molded integrally with the header part 42, and the joint pipe of the outlet 50 may be molded integrally with the footer part 52.

In the cooling structure 100 of FIGs 3 and 4, the joint pipes extends outward in a thickness direction of the cooling structure 100, but the orientation of the joint pipes are not limited to this. For example, the joint pipes may extend outward in a surface direction of the cooling structure 100. Alternatively, the joint pipe of the inlet 40 and the joint pipe of the outlet 50 may be oriented in different directions.

An inner core material 10 is disposed inside the outer packaging material 20 so that the inner core material 10 divides the flow path of the refrigerant flowing from the header part 42 to the footer part 52 into multiple parts. A periphery of the upper outer packaging material 20B and the lower outer packaging material 20A are closed to seal. In a case in which the outer packaging material 20A and the outer packaging material 20B have a resin layer, a periphery of the upper lower outer packaging material 20B and the lower outer packaging material 20A can be closed and sealed by fusing the resin layer.

A material of the inner core material 10 is not particularly limited, and may be a resin, a metal or the like, or may be a laminate material in which a metal layer and a resin layer are laminated. The inner core material 10 may have a metal layer and resin layers provided on both sides of the metal layer. In a case in which the surface of the inner core material 10 is made of resin, it may be fused to the outer packaging material 20. Furthermore, in a case in which the surface of the inner core material 10 is made of resin, an occurrence of corrosion due to the refrigerant is more easily suppressed.

The metal layer of the inner core material 10 may suitably be the same as the metal layer of the outer packaging material 20. The metal layer of the laminate material as the inner core material 10 may be made of the same material as the metal layer of the laminate material as the outer packaging material 20, or may be made of a different material.

The resin layer of the laminate material as the inner core material 10 may suitably be the same material as the resin layer of the laminate material as the outer packaging material 20. From the viewpoint of thermally fusing the inner core material 10 to the outer packaging material 20, it is preferable that the resin layer of the laminate material as the inner core material 10 and the resin layer of the laminate material as the outer packaging material 20 are made of the same material.

The laminate material as the inner core material 10 may be produced by attaching a resin film to a metal foil or metal plate. The resin film may be a stretched film or a non-stretched film. An adhesive may be used for attachment.

The inner core material 10 may be made of an elastically deformable material. For example, the inner core material 10 may be made of at least one material selected from the group consisting of metals such as iron and stainless steel, and resin. In one embodiment, the inner core material may be a metal layer such as iron or stainless steel coated with resin. The resin layer in this case is the same as the resin layer described above.

In a case in which the inner core material 10 is made of an elastically deformable material, even if the bottom of the concave portion 12 and the top of the convex portion 14 of the inner core material 10 are fused to the outer packaging material 20 and restrained, when an external force is applied from the lower outer packaging material 20A side or the upper outer packaging material 20B side, a region between the concave portion 12 and the convex portion 14 will bend and deform. Then, a thickness of the cooling structure 100 to which an external force is applied becomes thinner than a thickness of the cooling structure 100 before the external force is applied, while maintaining a state of being arranged along a surface of the object to be cooled.

Since the inner core material 10 is elastically deformable, when the external force is removed or reduced, a bending deformation returns to the original direction, and the thickness of the cooling structure 100 increases. In this way, in a case in which the inner core material 10 is made of an elastically deformable material, the cooling structure 100 becomes deformable due to the external force, and also becomes deformable in response to a shape and change in shape of the object to be cooled.

The concave and convex shape of the inner core material 10 may be formed into a corrugated shape by pressing, pleating or the like. It may not only be a corrugated shape, but also an embossed shape with concave and convex portions distributed like a houndstooth pattern.

The pressing may be a discontinuous press or a continuous press. Examples of the discontinuous press include a forming method using an upper plate and a lower plate, and Examples of the continuous press include a roll forming method. Examples of the roll forming method include a corrugated processing method.

In the forming method using an upper plate and a lower plate, each of the upper plate and the lower plate is formed so that the concave and convex portions are arranged alternately. Each concave portion of the upper plate corresponds to each convex portion of the lower plate, and each convex portion of the upper plate corresponds to each concave portion of the lower plate, and the upper plate and the lower plate are configured so that the concave and convex portions of each plate interlock with each other. The inner core before processing may be formed into a corrugated shape by sandwiching and pressing the inner core between the upper plate and the lower plate.

The corrugated processing method may be performed using a pair of corrugated rolls. Each corrugated roll is formed so that concave and convex portions are arranged alternately along a rotational direction on its outer circumferential surface. Each concave portion of one corrugated roll corresponds to each convex portion of the other corrugated roll, and each convex portion of one corrugated roll corresponds to each concave portion of the other corrugated roll, and the pair of corrugated rolls are configured so that their concave and convex portions interlock with each other. Then, by sandwiching the inner core material before processing between the pair of corrugated rolls and rotating them, the inner core material may be passed between the pair of corrugated rolls and formed into a corrugated sheet shape.

In a case in which embossing is performed in the roll forming method, a pair of embossing rolls may be used. For example, an embossing rolls are used, in which concave and convex portions of the embossing rolls are arranged alternately on the outer circumferential surface along a rotational direction and an axial direction. Furthermore, the pair of embossing rolls are arranged so that the concave portions of one embossing roll correspond to the convex portions of the other embossing roll, and the convex portions of one embossing roll correspond to the concave portions of the other embossing roll, so that the pair of embossing rolls are arranged so that the concave and convex portions interlock with each other. Then, the inner core material before processing is sandwiched between the pair of embossing rolls and rotated, and the inner core laminate material is passed between the pair of embossing rolls to process the concave and convex portions. This way makes it possible to produce an embossed inner core material with concave and convex portions distributed like a houndstooth pattern or the like.

In the continuous press processing, the inner core material processed with the concave and convex portions is cut to a predetermined length by a shear knife (shear cutting blade) or the like provided downstream of the processing device to form the inner core material 10. In the continuous press processing, the process may be performed continuously by roll-to-roll, and the production efficiency may be improved.

In a case in which the cross-sectional shape of the refrigerant flow path is not uniform, it is preferable to process the inner core material by discontinuous pressing.

In a case in which the inner core material 10 is made of resin, the concave and convex shapes may be formed by vacuum molding.

At least one of an interval between the convex portions 14 or an interval between the concave portions 12 may be from 2 mm to 10 mm. The interval between the convex portions 14 and the interval between the concave portions 12 may be adjusted as appropriate depending on a number of refrigerant flow paths separated by the concave and convex shape, an overall size of the cooling structure, or the like.

The interval between the convex portions 14 refers to a distance from one convex portion 14 to the next adjacent convex portion 14. In a case in which the top of the convex portion 14 has a flat surface, the interval between the convex portions 14 refers to a distance from an end point of the flat surface of one convex portion 14 to a start point of the flat surface of the next adjacent convex portion 14. In a case in which the top of the convex portion 14 is curved, the interval between the convex portions 14 refers to a distance from the highest point of one convex portion 14 to the highest point of the next adjacent convex portion 14.

The interval between the concave portions 12 refers to a distance from one concave portion 12 to the next adjacent concave portion 12. In a case in which the bottom of the concave portion 12 has a flat surface, the interval between the concave portions 12 refers to a distance from an end point of the flat surface of one concave portion 12 to a start point of the flat surface of the next adjacent concave portion 12. In a case in which the top of the concave portion 12 is curved, the interval between the concave portions 12 refers to a distance from the lowest point of one concave portion 12 to the lowest point of the next adjacent convex portion 14.

A cross-sectional shape of the refrigerant flow path partitioned by the concave and convex shapes of the inner core material 10 may be a semicircle, a semi-ellipse, a polygonal shape such as a triangle, a rectangle or a pentagon, an irregular shape, or a combination of these.

The multiple concave and convex shapes may be arranged regularly or irregularly. Examples of an irregular arrangement include one in which the period of the concave portion and convex portion is not uniform. In the case of a regular arrangement, the period of the concave portions and the period of the convex portions may be the same or different.

A refrigerant flows through the flow path that is partitioned into multiple parts by the concave and convex shape of the inner core material 10. A kind of the refrigerant is not particularly limited. Examples of the refrigerant include liquids such as water and organic solvents, and gases such as air. The water used as the refrigerant may contain components such as antifreeze.

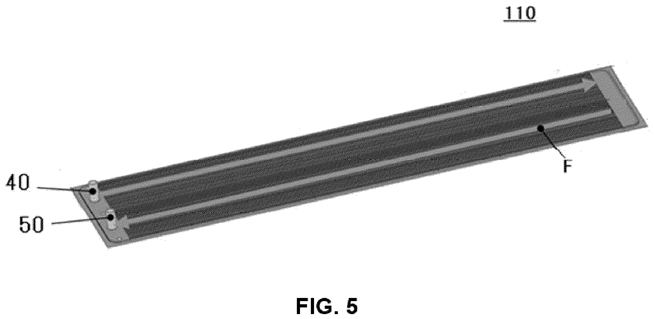

FIG. 5 is a schematic perspective view illustrating a modified example of the cooling structure, showing an interior in a case in which the upper outer packaging material 20B is removed.

In the cooling structure 100 of FIG. 3 and FIG. 4, the inlet 40 and outlet 50 for the refrigerant are provided at each end (front end, rear end) in the length direction. In contrast, in the cooling structure 110 of FIG. 5, both the inlet 40 and the outlet 50 are provided at one end. In the cooling structure 110 of FIG. 5, a joint pipe for the inlet 40 and a joint pipe for the outlet 50 are provided in the header section 42.

In the cooling structure 110 of FIG. 5, as shown by the arrow F in the figure, the refrigerant that flows from the inlet 40 of the header part 42 makes a U-turn at the footer part 52, reverses direction, and returns to the outlet 50 of the header section 42.

In FIG. 5, the refrigerant makes one round trip in the length direction, but it may make one and a half round trips. In this case, the header part 42 may be provided with an inlet 40, and the footer part 52 may be provided with an outlet 50. A number of times the refrigerant travels back and forth may be further increased.

In a case in which the refrigerant travels back and forth in the length direction, it is preferable to provide a partition between the forward flow path and the return flow path.

In yet another embodiment, there may be two or more inlets 40 and outlets 50, rather than just one each.

The cooling structure in the present disclosure may be widely used to cool heat-generating bodies, and is effective for cooling, for example, electronic devices such as smartphones and personal computers, battery modules mounted on electric vehicles, hybrid vehicles or the like, and power semiconductor modules.

### <Structure>

The structure in the present disclosure includes the cooling structure in the present disclosure described above, and an object to be cooled provided on the cooling structure.

Examples of the object to be cooled include heat-generating electronic devices such as smartphones and personal computers, battery modules mounted on electric vehicles and hybrid vehicles or the like, and power semiconductor modules.

The object to be cooled may be provided on either the outer packaging material 20B side or the outer packaging material 20A side of the cooling structure 100, or may be provided on both sides.

The present disclosure of Japanese Patent Application No. 2022-080052 is incorporated herein by reference in their entirety.

All documents, patent applications, and technical standards described in the present specification are incorporated herein by reference to the same extent as if each individual document, patent application, or technical standard were specifically and individually indicated to be incorporated by reference.

### Explanation of References

- 10: Inner core material
- 12: Convex portion
- 14: Concave portion
- 20, 20A, 20B: Outer packaging material
- 30, 31: Flow path
- 40: Inlet for refrigerant
- 50: Outlet for refrigerant
- 100: Cooling structure

## Claims

1. A cooling structure comprising an outer packaging material having an inlet and an outlet for a refrigerant, and an inner core material disposed inside the outer packaging material,
wherein the inner core material has a concave and convex shape that divides a flow path of the refrigerant into multiple sections, and
wherein at least one of an inclination from a concave portion to a convex portion or an inclination from a convex portion to a concave portion in the concave and convex shape is 10° or more and less than 90° with respect to a surface direction of the cooling structure.

2. The cooling structure according to claim 1, wherein at least one of a bottom of the concave portion or a top of the convex portion has a flat surface.

3. The cooling structure according to claim 2, wherein the flat surface is fused to the outer packaging material.

4. The cooling structure according to claim 1, wherein the outer packaging material comprises a metal layer and a resin layer provided on at least one surface of the metal layer.

5. The cooling structure according to claim 1, wherein the inner core material comprises a metal layer and a resin layer provided on both surfaces of the metal layer.

6. The cooling structure according to claim 1, wherein the inner core material is made of an elastically deformable material.

7. The cooling structure according to claim 1, wherein at least one of a spacing between concave portions or a spacing between convex portions is from 2 mm to 10 mm.

8. A structure comprising the cooling structure according to any one of claims 1 to 7 and an object to be cooled provided on the cooling structure.
